# EUROPÄISCHE PATENTSCHRIFT

(11) **EP 3 536 133 B1**
(45) Veröffentlichungstag und Bekanntmachung des Hinweises auf die Patenterteilung: **15.01.2025**
(21) Anmeldenummer: 17784532.8
(22) Anmeldetag: 04.10.2017
(51) Int. Cl.: H05K 1/14

(54) **ANSTEUERPLATINE FÜR EINEN KRAFTFAHRZEUGSCHEINWERFER**
CONTROL CIRCUIT BOARD FOR A MOTOR-VEHICLE HEADLAMP
CARTE ÉLECTRONIQUE DE COMMANDE POUR PROJECTEUR DE VÉHICULE À MOTEUR

(30) Priorität: 04.11.2016 AT 510102016
(43) Veröffentlichungstag der Anmeldung: 11.09.2019
(73) Patentinhaber: ZKW Group GmbH, 3250 Wieselburg (AT)
(72) Erfinder: WEBER, Emanuel, 2542 Kottingbrunn (AT); WACHTER, Roland, 7423 Grafenschachen (AT)
(74) Vertreter: Patentanwaltskanzlei Matschnig & Forsthuber OG
(86) Internationale Anmeldenummer: PCT/AT2017/060249
(87) Internationale Veröffentlichungsnummer: WO 2018/081842

(56) Entgegenhaltungen:
- WO-A1-2008/134809
- DE-A1- 102010 062 757
- DE-A1- 102015 004 339
- DE-B4- 102015 004 339
- GB-A- 2 503 597
- JP-U- S4 942 458
- US-A1- 2015 043 188

## Beschreibung

Die Erfindung betrifft eine Ansteuerplatine für einen Kraftfahrzeugscheinwerfer, auf welcher zumindest eine Steckergruppe mit baugleichen Steckern zum Anstecken von Steckergegenstücke aufweisende, den jeweiligen Steckern einer Steckergruppe eindeutig zugeordnete Leiterplatten angeordnet ist.

In der Automobilindustrie werden hohe Anforderungen an elektrische Steckerverbindungen gestellt, insbesondere im Hinblick auf unterschiedlich vorherrschende Umweltbedingungen in Teilen des Fahrzeugs.

So ist beispielsweise ein Frontscheinwerfer eines Fahrzeuges hohen Temperaturen und Vibrationsbelastungen ausgesetzt, wobei durch diese speziellen Anforderungen an Steckerverbindungssystemen die verfügbare Auswahl an geeigneten Steckerverbindungen am Markt limitiert ist.

Weiters kommt hinzu, dass bei der Montage von beispielsweise Leiterplatten bzw. Ansteuerplatinen, die mittels eines elektrischen Steckerverbindungssystems an weitere Bauteile gekoppelt sind, sichergestellt werden muss, dass ein Vertauschen oder ein falsches Anstecken der Stecker ausgeschlossen ist.

Um dies zu gewährleisten werden üblicherweise Steckerfamilien mit eigenem mechanischem Kodiersystem eingesetzt, wobei hierbei jeder Stecker mit zugeordnetem Steckergegenstück einen eigenen Steckmechanismus aufweist. Jedoch können gewisse Spezifikationen eines Systems, beispielsweise bei Leiterplatten, Steckerverbindungen erfordern, die für sich keine Kodierung implementiert haben bzw. zur Verfügung stellen. GB2503597A offenbart eine Leiterplatte gemäß dem Oberbegriff des unabhängigen Anspruchs. WO2008/134809A1 lehrt komplementäre Seitenränder, um zwei kompatible Leiterplatten zu verbinden und die Verbindung inkompatibler Leiterplatten zu verhindern.

Es ist daher Aufgabe der Erfindung eine Ansteuerplatine bereitzustellen, um oben erwähnte Nachteile und andere Einschränkungen des Standes der Technik zu vermeiden.

Diese Aufgabe wird dadurch gelöst, dass die Leiterplatten je an zumindest einer Seitenkante eine aufgrund ihrer Formgebung resultierende Kodierungsgeometrie aufweisen und bei benachbarten, im Sinne ihrer Zuordnung korrekt angesteckten Leiterplatten die Kodierungsgeometrie einer Seitenkante einer Leiterplatte zu einer Kodierungsgeometrie einer angrenzenden Seitenkante einer benachbarten Leiterplatte komplementär ist.

Auf diese Art und Weise werden Steckverbindungen bzw. Stecksysteme, die ursprünglich keine Kodierung aufweisen, mit einem Kodiersystem ausgestattet, das durch die jeweilige Anordnung der Stecker innerhalb einer Steckergruppe und der daraus korrelierenden Geometrie der Leiterplatten der Steckergegenstücke bestimmt ist.

Verwendete Steckverbindungen um Leiterplatten zu koppeln sind beispielsweise stapelbare Leiterplattensteckverbinder, Mezzanine-Steckverbinder, Backplane-Steckverbinder, sowie FH-Steckverbinder, wobei diese Aufzählung nicht abschließend ist.

Erfindungsgemäß werden nur Board-to-Board-Verbindungen berücksichtigt, wobei dies von starren bzw. festen Leiterplatten, beispielsweise einseitige bzw. zweiseitige Standardleiterplatten, sowie Multilayerplatten, bis hin zu dünnen, biegbaren Flexleiterplatten reicht.

Weiters sind die anfallenden Stückzahlen einzelner Stecker bei Steckerfamilien mit Kodieroption pro Bauteil deutlich niedriger als bei Verwendung von einem baugleichen Stecker. Dadurch ergibt sich eine klare Kostenreduktion.

Es kann vorgesehen sein, dass sich zumindest zwei von unterschiedlichen Steckergruppen benachbarte Leiterplatten durch ihre jeweilige Formgebung komplementär ergänzen. Weiters kann vorgesehen sein, dass die Kodierungsgeometrien der Leiterplatten von einer Geraden abweichende Ausnehmungen und Vorsprünge aufweisen, die sich komplementär ergänzen.

Dabei kann es zweckmäßig sein, wenn die Kodierungsgeometrien der Leiterplatten bogenförmig und/oder gezackt ausgebildet sind, wobei jedes erdenkliche Muster Anwendung finden kann.

Erfindungsgemäß ist vorgesehen, dass zumindest eine Steckergruppe einen ersten und zweiten Stecker aufweist, wobei ein Anstecken einer Leiterplatte auf einen dieser Leiterplatte nicht zugeordneten Stecker, ein Anstecken einer weiteren Leiterplatte auf den anderen Stecker innerhalb der Steckergruppe verhindert.

Vorteilhafterweise sind die Stecker einer Steckergruppe in einer Reihe mit gleichbleibendem Abstand auf der Ansteuerplatine angeordnet, wobei die Steckrichtungen der Stecker parallel zueinander ausgerichtet sind.

Hierbei ist ebenfalls auch eine Verdrehung der Steckrichtungen um 180° zueinander berücksichtigt, sodass Stecker mit entgegengesetzten Steckrichtungen angeordnet sein können.

Weiters kann vorgesehen sein, dass die Stecker einer Steckergruppe in einer Reihe mit gleichbleibendem Abstand auf der Ansteuerplatine angeordnet sind, wobei die Steckrichtungen von zumindest zwei benachbarten Steckern schräg zueinander ausgerichtet sind.

Vorteilhafterweise sind die Steckverbindungen zwischen den Steckern und der Steckergegenstücke der Leiterplatten lösbar.

Nachfolgend wird die Erfindung anhand von Zeichnungen näher beschrieben. Hierbei zeigen
Fig. 1 eine Draufsicht auf eine Ansteuerplatine mit zwei Steckergruppen umfassend jeweils drei Stecker,
Fig. 2 eine Draufsicht der Ansteuerplatine aus Fig. 1 mit angesteckten Leiterplatten,
Fig. 3 eine Detailansicht zweier Leiterplatten mit zueinander komplementär ergänzenden Formgebungen,
Fig. 4 eine Detailansicht von drei Leiterplatten mit zueinander komplementär ergänzenden Formgebungen,
Fig. 5 eine Detailansicht von zueinander komplementär ergänzenden Leiterplatten zweier Steckergruppen,
Fig. 6 eine Draufsicht auf eine Ansteuerplatine mit zwei Steckergruppen umfassend jeweils zwei Stecker,
Fig. 7 eine Draufsicht der Ansteuerplatine aus Fig. 6 mit angesteckten Leiterplatten,
Fig. 8 eine Draufsicht der Ansteuerplatine aus Fig. 6 mit angesteckten Leiterplatten auf diesen Leiterplatten nicht zugeordneten Steckern,
Fig. 9 eine Draufsicht auf eine weitere beispielhafte Ansteuerplatine umfassend zwei Steckergruppen mit jeweils zwei Steckern,
Fig. 10 eine Draufsicht der Ansteuerplatine aus Fig. 9 mit angesteckten Leiterplatten,
Fig. 11 eine Draufsicht der Ansteuerplatine aus Fig. 9 mit angesteckten Leiterplatten auf diesen Leiterplatten nicht zugeordneten Steckern,
Fig. 12 ein weiteres Beispiel einer Ansteuerplatine mit zwei Steckergruppen umfassend je zwei in einem Kippwinkel zueinander angeordneten Steckern,
Fig. 13 eine Draufsicht der Ansteuerplatine aus Fig. 12 mit angesteckten Leiterplatten,
Fig. 14 eine Draufsicht der Ansteuerplatine aus Fig. 12 mit einer angesteckten Leiterplatte auf einen dieser Leiterplatte nicht zugeordneten Stecker,
Fig. 15 ein weiteres Beispiel mit versetzten und zueinander verdrehten Steckern einer Steckergruppe auf einer Ansteuerplatine, und
Fig. 16 ein weiteres Beispiel mit zueinander verdrehten Steckern einer Steckergruppe auf einer Ansteuerplatine.

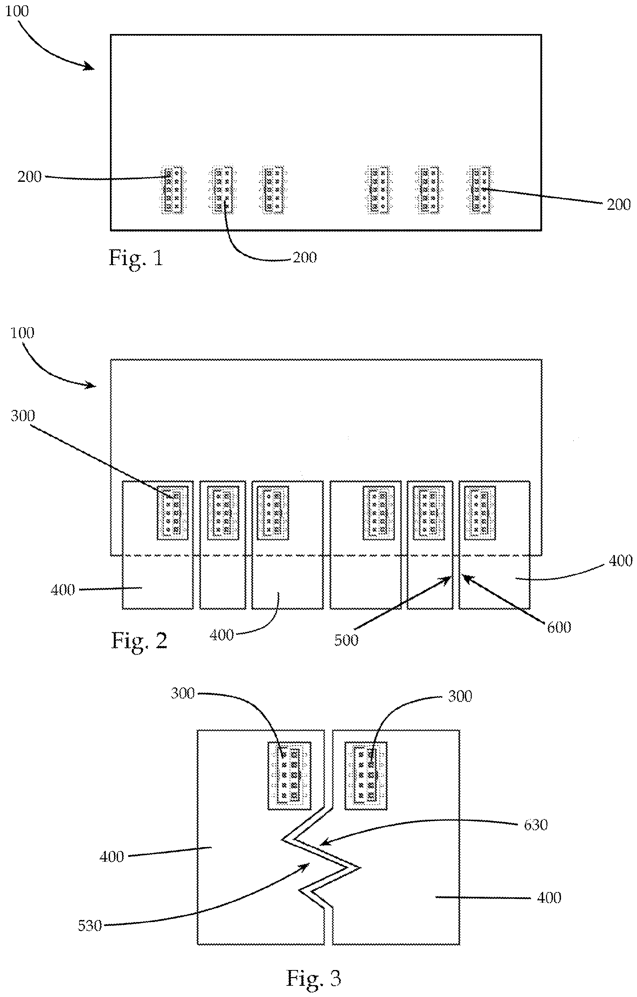

Fig. 1 zeigt eine Ansteuerplatine 100 eines Fahrzeugscheinwerfers mit darauf angeordneten Steckergruppen mit je drei baugleichen Steckern **200,** wobei jeder auf der Ansteuerplatine **100** angeordnete Stecker **200** baugleich ausgeführt sein kann.

Unter dem Begriff "Steckergruppe" werden jene Stecker zusammengefasst, die baugleich und in einer solchen Weise zueinander angeordnet und beabstandet sind, dass für einen Betrachter der Eindruck einer Zusammengehörigkeit entsteht, wobei Steckergruppen eine von anderen Steckergruppen verschiedene Anzahl von Steckern **200** aufweisen können. Ebenso können baugleiche Stecker **200** aufgrund ihrer Funktionen in Steckergruppen zusammengefasst werden.

Innerhalb einer Steckergruppe ist jedem Stecker **200** eine separate Leiterplatte **400, 401, 402, 403, 404, 411, 412, 413, 414** zugeordnet, die jeweils ein ebenfalls baugleiches Steckergegenstück **300** aufweist, das dazu geeignet ist, mit den baugleichen Steckern **200** innerhalb einer Steckergruppe eine Steckverbindung einzugehen.

Die in den Figuren dargestellten Stecker **200** weisen je eine bevorzugte Steckrichtung für die in den Figuren und weiteren Beispielen gleich aufgebauten Steckergegenstücke **300** auf, wobei die Steckergegenstücke **300** um 180 Grad verdreht auf die Stecker **200** gesteckt werden.

Zur erleichterten Darstellung sind die auf den Leiterplatten **400, 401, 402, 403, 404, 411, 412, 413, 414** angeordneten Steckergegenstücke **300** im angesteckten Zustand und aufrechter Steckverbindung auf der Ansteuerplatine **100,** ebenfalls eingezeichnet und mit einer Umrandung versehen, wie beispielsweise in **Fig. 2****,** obwohl diese eigentlich in den Draufsichten nicht sichtbar wären.

Es sei darauf hingewiesen, dass die in den Figuren dargestellten Stecker **200** sowie Steckergegenstücke **300** - und deren Stecksystem - lediglich als anschauliches Beispiel dienen und jede erdenkliche Art von Steckern und Steckergegenstücken, sowie Stecksysteme bzw. Steckverbindungsysteme, vorgesehen sein können.

Da die Leiterplatten **400, 401, 402, 403, 404, 411, 412, 413, 414** im Allgemeinen jeweils unterschiedliche Funktionen implementiert haben, muss sichergestellt werden, dass die Leiterplatten **400, 401, 402, 403, 404, 411, 412, 413, 414** bei einer Assemblierung auf den ihnen zugeordneten Steckern **200** angesteckt werden.

Um dies zu erreichen, sind die Leiterplatten **400, 401, 402, 403, 404, 411, 412, 413, 414** einer Steckergruppe unterschiedlich ausgeformt, sodass zumindest eine Seitenkante eine Kodierungsgeometrie **500, 600, 530, 630, 540, 640** aufweist, wobei bei einer Assemblierung aller Leiterplatten **400, 401, 402, 403, 404, 411, 412, 413, 414** einer Steckergruppe auf den jeweils vorgesehenen Steckern **200,** die Kodierungsgeometrie **500, 600, 530, 630, 540, 640** bei benachbarten, im Sinne ihrer Zuordnung korrekt angesteckten Leiterplatten **400, 401, 402, 403, 404, 411, 412, 413, 414** komplementär ergänzend ist.

Hierbei ist die Kodierungsgeometrie **500, 530, 540** einer Seitenkante einer Leiterplatte **400, 401, 402, 403, 404, 411, 412, 413, 414** zu einer Kodierungsgeometrie **600, 630, 640** einer angrenzenden Seitenkante einer benachbarten Leiterplatte **400** komplementär.

Abseits der komplementären Formgebungen weisen die Steckergegenstücke **300** auf den jeweiligen Leiterplatten **400, 401, 402, 403, 404, 411, 412, 413, 414** eine solche Position auf, sodass bei einem Anstecken einer Leiterplatte **400, 401, 402, 403, 404, 411, 412, 413, 414** auf einem dieser Leiterplatte **400, 401, 402, 403, 404, 411, 412, 413, 414** nicht zugeordneten Stecker **200** zumindest ein weiterer Stecker **200** innerhalb der Steckergruppe verdeckt wird, sodass ein Anstecken einer weiteren Leiterplatte **400, 401, 402, 403, 404, 411, 412, 413, 414** auf diesen verdeckten Stecker **200** verhindert wird.

Dahingehend könnte man auch von einer "asymmetrischen" Position der Steckergegenstücke **300** auf den jeweiligen Leiterplatten **400, 401, 402, 403, 404, 411, 412, 413, 414** sprechen, wobei damit gemeint ist, dass die Leiterplatte **400, 401, 402, 403, 404, 411, 412, 413, 414** mitsamt des darauf angeordneten Steckergegenstücks **300** keine Achsen- und/oder Punktsymmetrien aufweist, selbst wenn die Formgebung der Leiterplatte **400, 401, 402, 403, 404, 411, 412, 413, 414** ohne Steckergegenstück **300** eine solche Symmetrie aufweist bzw. aufgewiesen hat.

In **Fig. 2** ist eine mögliche Ausführungsform der angesteckten Leiterplatten **400** auf der Ansteuerplatine **1** aus **Fig. 1** dargestellt, wobei hierbei die Leiterplatten **400** eine rechteckige Form aufweisen und jeweils zwei Steckergegenstücke **300** eine solche Position auf den jeweiligen Leiterplatten **400** einer Steckergruppe aufweisen, die oben beschrieben ist.

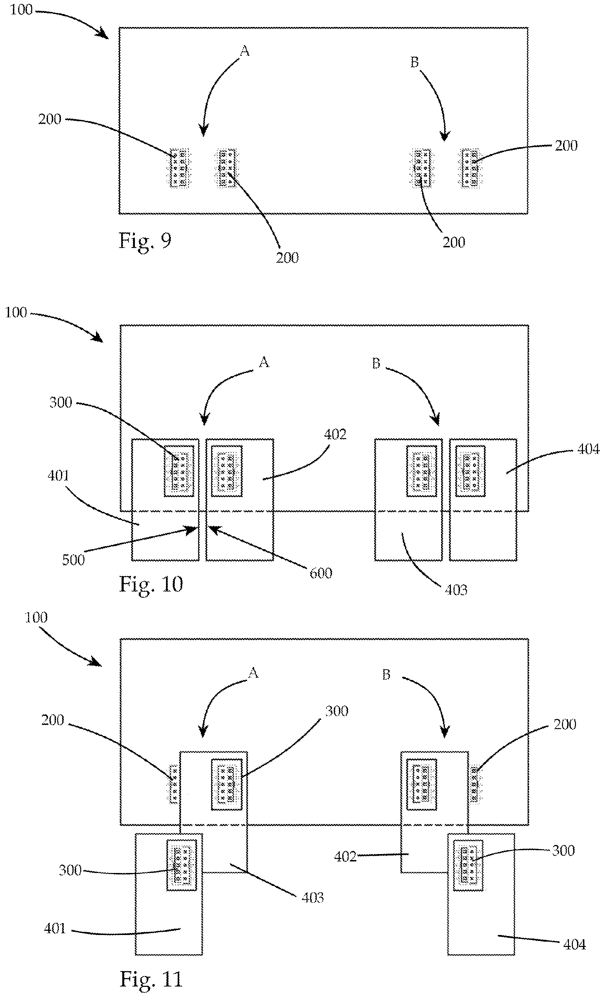

Es sei angemerkt, dass Leiterplatten im Allgemeinen, und dort wo es aus Gründen der Übersichtlichkeit bzw. Lesbarkeit zweckdienlich ist, lediglich mit dem Bezugszeichen "400" versehen sind, wobei in den **Fig. 10,11****,****13** und **14** aufgrund notwendiger Erklärungen spezifischere Bezugszeichen für die darin enthaltenen Leiterplatten verwendet werden.

In den vorherig genannten Beispielen ist die Form der Leiterplatten **400** als Rechteck ausgeführt, wobei ein weiteres mögliches Beispiel zur Formgebung der Leiterplatten **400** in **Fig. 3** gezeigt ist.

Hierbei sind zwei Leiterplatten **400** dargestellt, die im Wesentlichen eine rechteckige Form aufweisen, wobei die in aufrechter Steckverbindung benachbarten Seiten bzw. Kanten der Leiterplatten **400** jeweils ein komplementär zueinander geformtes Zick-Zack Muster aufweisen.

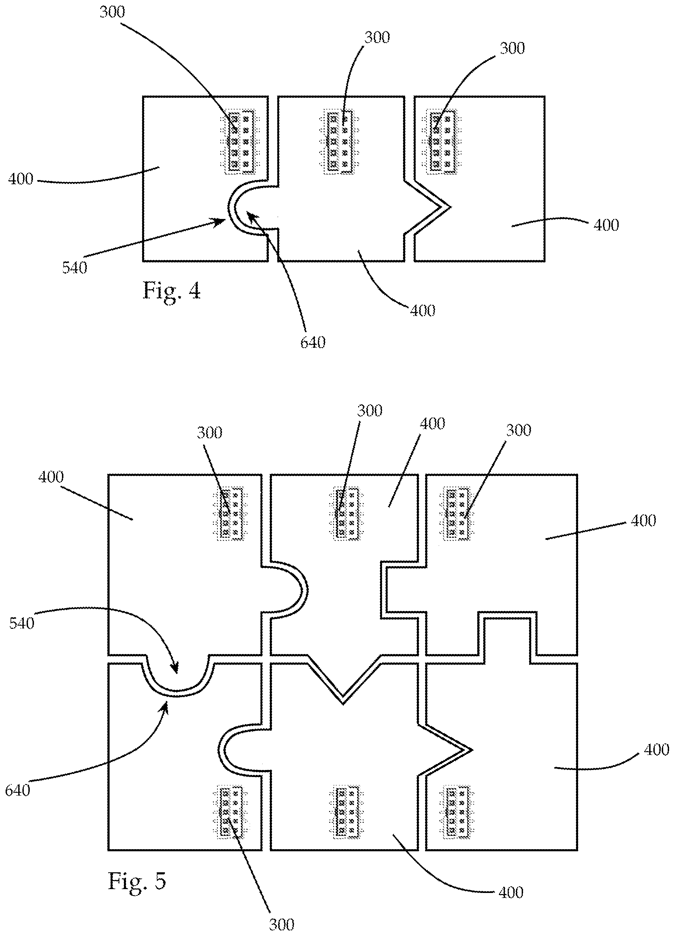

Es können auch andere Muster bzw. Formen zur komplementären Formgebung der Leiterplatten **400** verwendet werden, wie zum Beispiel bogenförmige Ausformungen, wobei auch mehrere unterschiedliche Formen auf einer Leiterplatte **400** realisiert sein können. **Fig. 4** zeigt eine solche Ausführungsform, bei welcher für benachbarte Leiterplatten **400** unterschiedliche komplementäre Formgebungen realisiert sind.

Bisher wurden ausschließlich Leiterplatten **400** und deren Formgebungen innerhalb einer Steckergruppe berücksichtigt, wobei sich ebenso zumindest zwei von unterschiedlichen Steckergruppen benachbarte Leiterplatten **400** durch ihre jeweilige Formgebung komplementär ergänzen können, wie in **Fig. 5** dargestellt.

Es sei hinzugefügt, dass die speziell in den **Fig. 4** und **5** enthaltenen, unterschiedlichen Kodierungsgeometrien nicht alle mit Bezugszeichen versehen sind, da diese Figuren lediglich das angewendete Prinzip veranschaulichen sollen, und die dazu verwendeten Formen für die einzelnen Kodierungsgeometrien symbolisch zu verstehen sind.

Durch die gezielte komplementäre Formgebung der Leiterplatten **400** soll ausgeschlossen werden, dass bei einem Anstecken bzw. Assemblierung aller Leiterplatten **400** einer Steckergruppe, diese an einen ihnen nicht zugeordneten Stecker **200** angesteckt werden.

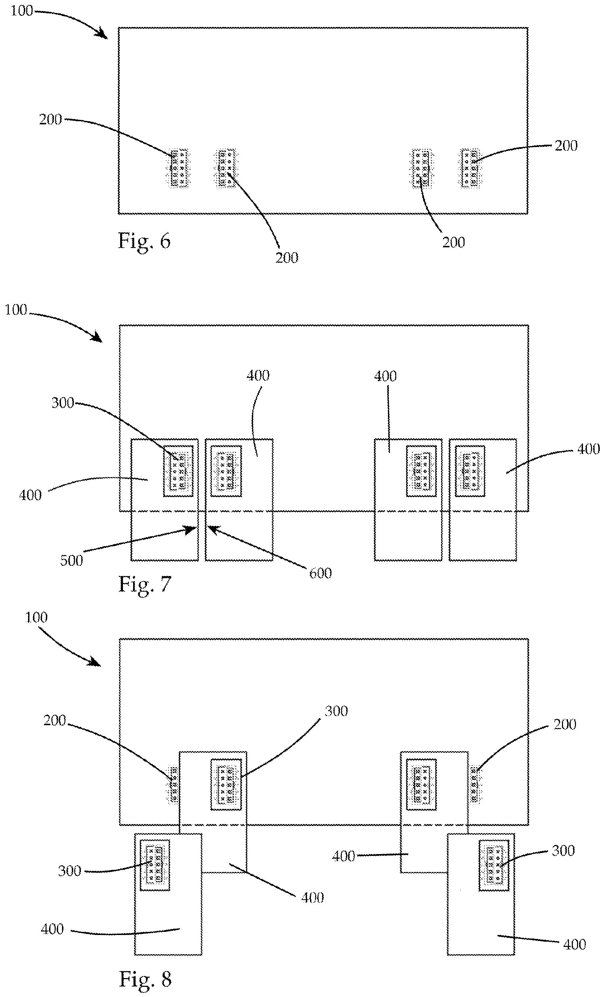

Bei dem in **Fig. 6, 7** und **8** gezeigten Beispiel, mit genau zwei Steckern **200** in einer Steckergruppe, ist die Formgebung und die Position der Steckergegenstücke **300** auf den jeweiligen Leiterplatten **400** so gewählt, dass bereits ein falsches Anstecken einer Leiterplatte **400** auf einen nicht zugeordneten Stecker **200** dazu führt, dass der andere Stecker **200** der Steckergruppe verdeckt wird, sodass ein Anstecken einer weiteren Leiterplatte **400** verhindert wird. Somit ist es möglich, dass bei einer Steckergruppe mit zwei baugleichen Steckern **200** nur ein Stecker **200** durch eine Leiterplatte **400** besetzt sein kann, da ein falsches Anstecken einer Leiterplatte **400** auf einen nicht zugeordneten Stecker **200** sofort ersichtlich ist.

Zu beachten ist, dass die Steckergruppen aus dem Beispiel in **Fig. 6, 7** und **8** unterschiedliche Steckrichtungen aufweisen. So weisen die Steckrichtungen der Stecker **200** einer Steckergruppe in eine gemeinsame Richtung, wobei die Stecker **200** der anderen Steckergruppe in die entgegengesetzte Richtung angeordnet sind.

In dem in **Fig. 9,10** und **11** gezeigten Beispiel, weist die Ansteuerplatine **100** eine erste und zweite Steckergruppe **A, B** auf, wobei die Stecker der ersten Steckergruppe **A** zueinander gespiegelte Steckrichtungen aufweisen, und die Stecker der zweiten Steckergruppe **B** je mit zur ersten Steckergruppe **A** entgegengesetzten Steckrichtungen angeordnet sind.

Im Gegensatz zu dem in **Fig. 6, 7** und **8** gezeigten Beispiel können die Leiterplatten **401, 402, 403, 404** des in **Fig. 9,10** und **11** dargestellten Beispiels aufgrund der Anordnung der Steckrichtungen der Stecker **200** innerhalb ihrer jeweiligen Steckergruppe um 180 Grad verdreht, jedoch nicht im Sinne ihrer Zuordnung, ebenfalls gleichzeitig angesteckt werden, wobei ein gleichzeitiges Anstecken der Leiterplatten **401, 402, 403, 404** einer nicht zugeordneten Steckergruppe **A, B** aufgrund der Anordnung der Steckrichtungen der Stecker **200** verhindert wird.

**Fig. 11** zeigt eine in der ersten Steckergruppe **A** nicht zugeordnete Leiterplatte **403** der zweiten Steckergruppe **B,** welche ein Anstecken einer weiteren Leiterplatte **401** der ersten Steckergruppe **A** verhindert, sowie eine in der zweiten Steckergruppe **B** nicht zugeordnete Leiterplatte **402** der ersten Steckergruppe **A,** welche ein Anstecken einer weiteren Leiterplatte **404** der zweiten Steckergruppe **B** verhindert.

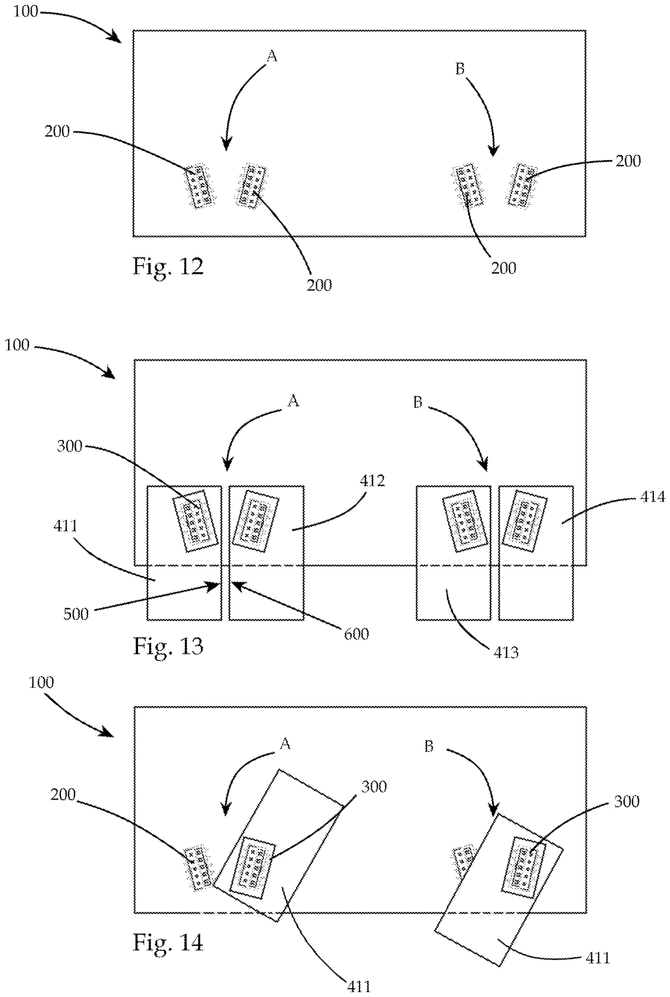

**Fig. 12,13** und **14** zeigen ein weiteres Beispiel, wobei die Stecker **200** der jeweiligen Steckergruppen **A, B** zusätzlich zur Ausrichtung der Steckrichtung, gemäß des Beispiels aus **Fig. 9,10** und **11****,** zueinander verdreht bzw. verkippt sind.

Auf den zugeordneten Leiterplatten **411, 412, 413, 414** dieser verdrehten Stecker **200,** ist das Steckergegenstück **300** ebenfalls um denselben Winkel verdreht, sodass sich bei einer aufrechten Steckverbindung aller Leiterplatten **411, 412, 413, 414** dieser Steckergruppe die Formen bzw. Kodierungsgeometrien **500, 600** von benachbarten Leiterplatten **411, 412, 413, 414** komplementär ergänzen.

Durch diesen zusätzlichen Kippwinkel ist gewährleistet, dass die Leiterplatten **411, 412, 413, 414** ausschließlich im Sinne ihrer Zuordnung an den jeweiligen Steckern **200** angeordnet werden können.

Mit "zueinander verdreht angeordnet" ist im weitesten Sinn gemeint, dass die Stecker **200** einer Steckergruppe vorzugsweise in einer Reihe mit gleichbleibenden Abstand auf der Ansteuerplatine **100** angeordnet sind, wobei die Steckrichtungen von zumindest zwei benachbarten Steckern **200** nicht parallel zueinander ausgerichtet sind.

**Fig. 14** zeigt eine der ersten Steckergruppe **A** zugeordnete Leiterplatte **411,** welche einmal innerhalb der ersten Steckergruppe **A** auf einem ihr nicht zugeordneten Stecker **200** angesteckt ist, sowie einmal angeordnet bzw. angesteckt auf einem Stecker **200** der dieser Leiterplatte **411** nicht zugeordneten zweiten Steckergruppe **B.** In beiden Fällen ist sofort ersichtlich, dass ein Anstecken einer weiteren Leiterplatte **412, 413, 414** nicht möglich ist bzw. sich die Kodierungsgeometrien **500, 600** nicht komplementär ergänzen.

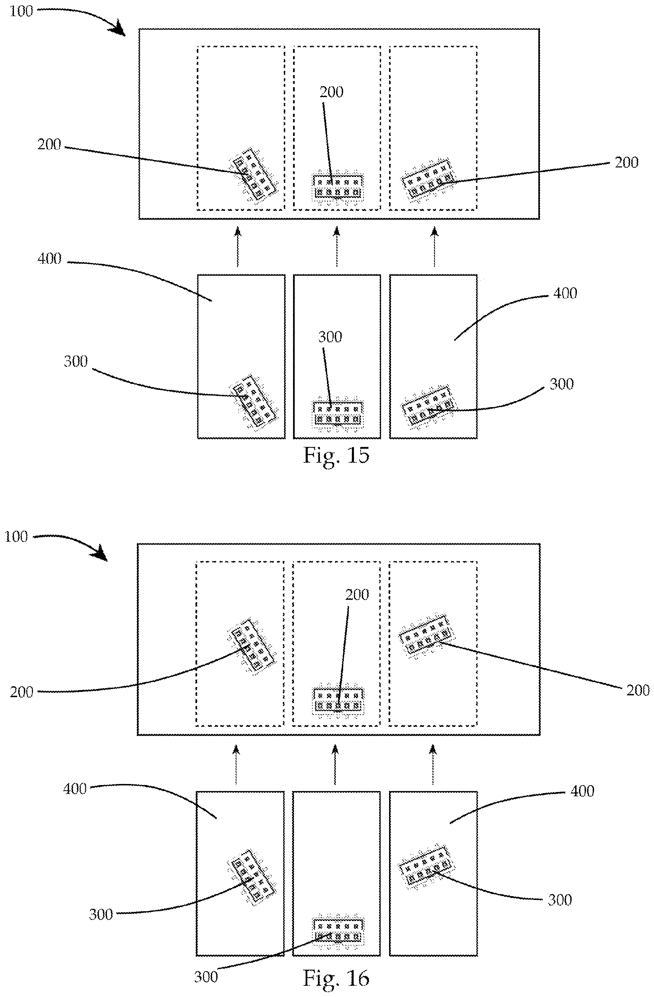

**Fig. 15** und **16** zeigen weitere erfindungsgemäße Beispiele. Hierbei wurden die Anordnungen der Stecker **200** und Steckrichtungen auf drei Stecker **200** einer Steckergruppe angewendet, wobei in **Fig. 16** die Stecker **200** zueinander verdreht und zusätzlich versetzt zueinander angeordnet sind.

Es sei darauf hingewiesen, dass die angesteckten bzw. korrekt angesteckten Leiterplatten auf der Ansteuerplatine koplanar angeordnet sind, d.h. dass sich die angesteckten Leiterplatten im Wesentlichen in einer gemeinsamen Ebene erstrecken.

### LISTE DER BEZUGSZEICHEN

| | |
|---|---|
| Ansteuerplatine | 100 |
| Stecker | 200 |
| Steckergegenstück | 300 |
| Leiterplatte | 400, 401, 402, 403, 404, 411, 412, 413, 414 |
| Kodierungsgeometrie | 500, 600, 530, 630, 540, 640, |
| erste Steckergruppe | A |
| zweite Steckergruppe | B |

## Patentansprüche

1. Ansteuerplatine (100) für einen Kraftfahrzeugscheinwerfer, auf welcher zumindest eine Steckergruppe (A, B) mit baugleichen Steckern (200) zum Anstecken von Steckergegenstücke (300) aufweisende, den jeweiligen Steckern (200) einer Steckergruppe eindeutig zugeordnete Leiterplatten (400, 401, 402, 403, 404, 411, 412, 413, 414) angeordnet ist, wobei die Steckverbindungen zwischen den Steckern (200) und der Steckergegenstücke (300) der Leiterplatten (400, 401, 402,403, 404, 411, 412, 413, 414) lösbar sind,
**dadurch gekennzeichnet, dass**
die Leiterplatten (400, 401, 402, 403, 404, 411, 412, 413, 414) je an zumindest einer Seitenkante eine aufgrund ihrer Formgebung resultierende Kodierungsgeometrie (500, 600, 530, 630, 540, 640) aufweisen und bei benachbarten, im Sinne ihrer Zuordnung korrekt angesteckten Leiterplatten (400, 401, 402, 403, 404, 411, 412, 413, 414) die Kodierungsgeometrie (500, 530, 540) einer Seitenkante einer Leiterplatte (400, 401, 402, 403, 404, 411, 412, 413, 414) zu einer Kodierungsgeometrie (600, 630, 640) einer angrenzenden Seitenkante einer benachbarten Leiterplatte (400, 401, 402, 403, 404, 411, 412, 413, 414) komplementär ist, wobei
die Steckergegenstücke (300) auf den jeweiligen Leiterplatten eine solche Position aufweisen, sodass bei einem Anstecken einer Leiterplatte auf einem dieser Leiterplatte nicht zugeordneter Stecker zumindest ein weiterer Stecker (200) innerhalb der Steckergruppe verdeckt wird, sodass ein Anstecken einer weiteren Leiterplatte auf diesen verdeckten Stecker (200) verhindert wird.

2. Ansteuerplatine (100) nach Anspruch 1, **dadurch gekennzeichnet, dass** sich die Kodierungsgeometrien (500, 600, 530, 630, 540, 640) von zumindest zwei in unterschiedlichen Steckergruppen benachbarten, im Sinne ihrer Zuordnung korrekt angesteckten Leiterplatten (400, 401, 402, 403, 404, 411, 412, 413, 414) komplementär ergänzen.

3. Ansteuerplatine (100) nach Anspruch 1 oder 2, **dadurch gekennzeichnet, dass** die Kodierungsgeometrien (500, 600, 530, 630, 540, 640) der Leiterplatten (400, 401, 402, 403, 404, 411, 412, 413, 414) von einer Geraden abweichende Ausnehmungen und Vorsprünge aufweisen, die sich komplementär ergänzen.

4. Ansteuerplatine (100) nach Anspruch 3, **dadurch gekennzeichnet, dass** die Kodierungsgeometrien (500, 600, 530, 630, 540, 640) der Leiterplatten (400, 401, 402, 403, 404, 411, 412, 413, 414) bogenförmig und/oder gezackt ausgebildet sind.

5. Ansteuerplatine (100) nach einem der Ansprüche 1 bis 4, **dadurch gekennzeichnet, dass** die Stecker (200) einer Steckergruppe in einer Reihe mit gleichbleibendem Abstand auf der Ansteuerplatine (100) angeordnet sind, wobei die Steckrichtungen der Stecker (200) parallel zueinander ausgerichtet sind.

6. Ansteuerplatine (100) nach einem der Ansprüche 1 bis 5, **dadurch gekennzeichnet, dass** zumindest eine Steckergruppe genau zwei Stecker (200) aufweist, wobei ein Anstecken einer Leiterplatte (400, 401, 402, 403, 404, 411, 412, 413, 414) auf einen dieser Leiterplatte (400, 401, 402, 403, 404, 411, 412, 413, 414) nicht zugeordneten Stecker (200), ein Anstecken einer weiteren Leiterplatte (400, 401, 402, 403, 404, 411, 412, 413, 414) auf den anderen Stecker (200) innerhalb der Steckergruppe verhindert.

7. Ansteuerplatine (100) nach einem der Ansprüche 1 bis 5, **dadurch gekennzeichnet, dass** die Stecker (200) einer Steckergruppe in einer Reihe mit gleichbleibendem Abstand auf der Ansteuerplatine (100) angeordnet sind, wobei die Steckrichtungen von zumindest zwei benachbarten Steckern (200) schräg zueinander ausgerichtet sind.

8. Ansteuerplatine (100) nach einem der Ansprüche 1 bis 5, **dadurch gekennzeichnet, dass** die Stecker (200) einer Steckergruppe in einer Reihe mit gleichbleibendem Abstand auf der Ansteuerplatine (100) angeordnet sind, wobei die Steckrichtungen von zumindest zwei benachbarten Steckern (200) orthogonal zueinander ausgerichtet sind.

9. Ansteuerplatine (100) nach einem der Ansprüche 1 bis 8, **dadurch gekennzeichnet, dass** die Stecker (200) einer Steckergruppe in einer Reihe auf der Ansteuerplatine (100) angeordnet sind, wobei zumindest ein Stecker (200) eine von der Reihe versetzte Position aufweist.

10. Ansteuerplatine (100) nach Anspruch 9, **dadurch gekennzeichnet, dass** die Steckrichtungen von zumindest zwei benachbarten Steckern (200) schräg zueinander ausgerichtet sind.

11. Ansteuerplatine (100) nach Anspruch 10, **dadurch gekennzeichnet, dass** zumindest eine Steckergruppe genau drei Stecker (200) aufweist, wobei ein Anstecken einer Leiterplatte (400, 401, 402, 403, 404, 411, 412, 413, 414) auf einen dieser Leiterplatte (400, 401, 402, 403, 404, 411, 412, 413, 414) nicht zugeordneten Stecker (200), ein Anstecken einer weiteren Leiterplatte (400, 401, 402, 403, 404, 411, 412, 413, 414) auf andere Stecker (200) innerhalb der Steckergruppe verhindert.

12. Kraftfahrzeugscheinwerfer mit zumindest einer Ansteuerplatine (100) gemäß einem der Ansprüche 1 bis 11.

## Claims

1. Control board (100) for a motor vehicle headlamp, on which at least one plug group (A, B) with identical plugs (200) for plugging in plug counterparts (300) is arranged, having printed circuit boards (400, 401, 402, 403, 404, 411, 412, 413, 414), the plug connections between the plugs (200) and the plug counterparts (300) of the printed circuit boards (400, 401, 402, 403, 404, 411, 412, 413, 414) being detachable,
**characterized in that**
the printed circuit boards (400, 401, 402, 403, 404, 411, 412, 413, 414) each have on at least one side edge a coding geometry (500, 600, 530, 630, 540, 640) resulting from their shape and, in the case of adjacent printed circuit boards (400, 401, 402, 403, 404, 411, 412, 413, 414), the coding geometry (500, 530, 540) of a side edge of a printed circuit board (400, 401, 402, 403, 404, 411, 412, 413, 414) is complementary to a coding geometry (600, 630, 640) of an adjacent side edge of an adjacent printed circuit board (400, 401, 402, 403, 404, 411, 412, 413, 414), wherein
the connector counterparts (300) on the respective printed circuit boards have such a position that, when a printed circuit board is plugged onto a connector not assigned to this printed circuit board, at least one further connector (200) within the connector group is covered, so that plugging of a further printed circuit board onto this covered connector (200) is prevented.

2. Control board (100) according to claim 1, **characterized in that** the coding geometries (500, 600, 530, 630, 540, 640) of at least two printed circuit boards (400, 401, 402, 403, 404, 411, 412, 413, 414) which are adjacent in different connector groups and correctly plugged in in terms of their assignment complement each other.

3. Control board (100) according to claim 1 or 2, **characterized in that** the coding geometries (500, 600, 530, 630, 540, 640) of the printed circuit boards (400, 401, 402, 403, 404, 411, 412, 413, 414) have recesses and projections which deviate from a straight line and complement each other.

4. Control board (100) according to claim 3, **characterized in that** the coding geometries (500, 600, 530, 630, 540, 640) of the printed circuit boards (400, 401, 402, 403, 404, 411, 412, 413, 414) are arcuate and/or serrated.

5. Control board (100) according to one of claims 1 to 4, **characterized in that** the plugs (200) of a plug group are arranged in a row with constant spacing on the control board (100), the plug directions of the plugs (200) being aligned parallel to one another.

6. Control board (100) according to one of claims 1 to 5, **characterized in that** at least one plug group has exactly two plugs (200), wherein plugging a printed circuit board (400, 401, 402, 403, 404, 411, 412, 413, 414) onto one of these printed circuit boards (400, 401, 402, 403, 404, 411, 412, 413, 414) to a connector (200) not assigned to this printed circuit board (400, 401, 402, 403, 404, 411, 412, 413, 414), prevents the connection of another printed circuit board (400, 401, 402, 403, 404, 411, 412, 413, 414) to the other connector (200) within the connector group.

7. Control board (100) according to one of claims 1 to 5, **characterized in that** the plugs (200) of a plug group are arranged in a row with constant spacing on the control board (100), the plug directions of at least two adjacent plugs (200) being aligned at an angle to one another.

8. Control board (100) according to one of claims 1 to 5, **characterized in that** the plugs (200) of a plug group are arranged in a row with constant spacing on the control board (100), the plug directions of at least two adjacent plugs (200) being aligned orthogonally to one another.

9. Control board (100) according to one of claims 1 to 8, **characterized in that** the plugs (200) of a plug group are arranged in a row on the control board (100), at least one plug (200) having a position offset from the row.

10. Control board (100) according to claim 9, **characterized in that** the plug-in directions of at least two adjacent plugs (200) are aligned at an angle to one another.

11. Control board (100) according to claim 10, **characterized in that** at least one plug group has exactly three plugs (200), wherein plugging a printed circuit board (400, 401, 402, 403, 404, 411, 412, 413, 414) onto one of these printed circuit boards (400, 401, 402, 403, 404, 411, 412, 413, 414) to a plug (200) not assigned to this printed circuit board (400, 401, 402, 403, 404, 411, 412, 413, 414), prevents the plugging of a further printed circuit board (400, 401, 402, 403, 404, 411, 412, 413, 414) to other plugs (200) within the plug group.

12. Motor vehicle headlamp with at least one control board (100) according to one of claims 1 to 11.

## Revendications

1. Platine de commande (100) pour un projecteur de véhicule automobile, sur laquelle sont disposés au moins un groupe de connecteurs (A, B) avec des connecteurs (200) de même construction pour l'enfichage de contreparties de connecteur (300), des cartes de circuits imprimés (400, 401, 402, 403, 404, 411, 412, 413, 414), les connexions par enfichage entre les connecteurs (200) et les contreparties de connecteur (300) des cartes imprimées (400, 401, 402, 403, 404, 411, 412, 413, 414) étant amovibles,
**caractérisé en ce que**
les cartes à circuits imprimés (400, 401, 402, 403, 404, 411, 412, 413, 414) présentent chacune sur au moins un bord latéral une géométrie de codage (500, 600, 530, 630, 540, 640) résultant de leur forme et, pour des cartes à circuits imprimés voisines (400, 401, 402, 403, 404, 411, 412, 413, 414), la géométrie de codage (500, 530, 540) d'un bord latéral d'une carte de circuit imprimé (400, 401, 402, 403, 404, 411, 412, 413, 414) est complémentaire d'une géométrie de codage (600, 630, 640) d'un bord latéral adjacent d'une carte de circuit imprimé voisine (400, 401, 402, 403, 404, 411, 412, 413, 414), où
les contreparties de connecteur (300) sur les cartes de circuits imprimés respectives présentent une position telle que, lors de l'enfichage d'une carte de circuits imprimés sur un connecteur non associé à cette carte de circuits imprimés, au moins un autre connecteur (200) est recouvert à l'intérieur du groupe de connecteurs, de sorte que l'enfichage d'une autre carte de circuits imprimés sur ce connecteur recouvert (200) est empêché.

2. Platine de commande (100) selon la revendication 1, **caractérisée en ce que** les géométries de codage (500, 600, 530, 630, 540, 640) d'au moins deux cartes à circuits imprimés (400, 401, 402, 403, 404, 411, 412, 413, 414) voisines dans des groupes de connecteurs différents et enfichées correctement au sens de leur affectation se complètent.

3. Platine de commande (100) selon la revendication 1 ou 2, **caractérisée en ce que** les géométries de codage (500, 600, 530, 630, 540, 640) des circuits imprimés (400, 401, 402, 403, 404, 411, 412, 413, 414) présentent des évidements et des saillies qui s'écartent d'une ligne droite et qui se complètent.

4. Platine de commande (100) selon la revendication 3, **caractérisée en ce que** les géométries de codage (500, 600, 530, 630, 540, 640) des circuits imprimés (400, 401, 402, 403, 404, 411, 412, 413, 414) sont en forme d'arc et/ou dentelées.

5. Platine de commande (100) selon l'une des revendications 1 à 4, **caractérisée en ce que** les connecteurs (200) d'un groupe de connecteurs sont disposés en une rangée à distance constante sur la platine de commande (100), les directions d'enfichage des connecteurs (200) étant orientées parallèlement les unes aux autres.

6. Platine de commande (100) selon l'une des revendications 1 à 5, **caractérisée en ce qu'**au moins un groupe de connecteurs présente exactement deux connecteurs (200), un enfichage d'une carte de circuit imprimé (400, 401, 402, 403, 404, 411, 412, 413, 414) sur l'une de ces cartes de circuit imprimé (400, 401, 402, 403, 404, 411, 412, 413, 414) non attribuée, empêche l'enfichage d'une autre carte à circuits imprimés (400, 401, 402, 403, 404, 411, 412, 413, 414) sur l'autre connecteur (200) à l'intérieur du groupe de connecteurs.

7. Platine de commande (100) selon l'une des revendications 1 à 5, **caractérisée en ce que** les connecteurs (200) d'un groupe de connecteurs sont disposés en une rangée à distance constante sur la platine de commande (100), les directions d'enfichage d'au moins deux connecteurs (200) voisins étant orientées obliquement les unes par rapport aux autres.

8. Platine de commande (100) selon l'une des revendications 1 à 5, **caractérisée en ce que** les connecteurs (200) d'un groupe de connecteurs sont disposés en une rangée à distance constante sur la platine de commande (100), les directions d'enfichage d'au moins deux connecteurs (200) voisins étant orientées orthogonalement les unes par rapport aux autres.

9. Platine de commande (100) selon l'une des revendications 1 à 8, **caractérisée en ce que** les connecteurs (200) d'un groupe de connecteurs sont disposés en une rangée sur la platine de commande (100), au moins un connecteur (200) présentant une position décalée par rapport à la rangée.

10. Platine de commande (100) selon la revendication 9, **caractérisée en ce que** les directions d'enfichage d'au moins deux connecteurs (200) voisins sont orientées obliquement les unes par rapport aux autres.

11. Platine de commande (100) selon la revendication 10, **caractérisée en ce qu'**au moins un groupe de connecteurs comporte exactement trois connecteurs (200), un branchement d'une carte de circuit imprimé (400, 401, 402, 403, 404, 411, 412, 413, 414) sur une carte de circuit imprimé (400, 401, 402, 403, 404, 411, 412, 413, 414) non affecté à un connecteur (200), empêche l'enfichage d'une autre carte à circuits imprimés (400, 401, 402, 403, 404, 411, 412, 413, 414) sur d'autres connecteurs (200) à l'intérieur du groupe de connecteurs.

12. Projecteur de véhicule automobile comportant au moins une carte de commande (100) selon l'une quelconque des revendications 1 à 11.
